# DEMANDE DE BREVET EUROPEEN

(11) **EP 1 978 560 A1**
(43) Date de publication de la demande: **08.10.2008**
(21) Numéro de dépôt: 08103296.3
(22) Date de dépôt: 01.04.2008
(51) Int. Cl.: H01L 23/498, H01L 23/50

(54) **Plaque de connexion électrique et assemblage d'une telle plaque et d'un composant semi-conducteur comprenant une puce de circuits intégrés.**

(30) Priorité: 04.04.2007 FR 0754261
(71) Demandeur: STMicroelectronics SA, 92120 Montrouge (FR)
(72) Inventeur: Bormann, Pierre, 38210, TULLINS (FR); Morineau, Luc, 38920, CROLLES (FR); Chavade, Jacques, 38430, MOIRANS (FR)
(74) Mandataire: Zapalowicz, Francis

(57) **Abrégé**

Plaque de connexion électrique comprenant, sur une face, des plots de connexion électrique en vue de connecter un composant semiconducteur et des pistes de connexion électrique reliées respectivement à ces plots, ces plots étant disposés selon une matrice carrée présentant deux directions orthogonales. La plaque comprend, sur sa face, une multiplicité de groupes identiques adjacents de connexion électrique (19), comprenant chacun N plots adjacents (20) et N pistes (23) placées selon cette direction en allant vers un bord de la matrice. Les plots d'un groupe sont décalés d'un pas par rapport aux plots du groupe adjacent.

Assemblage comprenant ladite plaque et un composant semiconducteur, reliés entre eux par des billes de connexion électrique.

## Description

La présente invention concerne le domaine du montage de composants semi-conducteurs, renfermant une ou des puces de circuits intégrés, sur une plaque de connexion électrique en vue de relier ce composant à d'autres composants électroniques également montés sur cette plaque.

D'une manière générale, il est connu de monter le composant semi-conducteur sur la plaque par l'intermédiaire de billes de connexion électrique qui relient des plots de connexion électrique prévus sur une face du composant semi-conducteur et des plots de connexion électrique de la plaque. Les billes de connexion électrique, et en conséquence les plots de connexion électrique du composant semi-conducteur et ceux de la plaque, sont en général répartis selon une matrice carrée, les billes adjacentes des rangées de billes étant toutes alignées parallèlement aux flancs du composant semi-conducteur et adjacentes.

Couramment, on prévoit des rangées de billes réparties sur la périphérie de la face du composant semi-conducteur et, dans certains cas, des rangées au centre de cette face, espacées par rapport aux plots périphériques. Dans d'autres cas, on prévoit des billes sur toute la face du composant semi-conducteur.

Pour effectuer le routage, c'est-à-dire la connexion des plots de la plaque vers d'autres composants portés par cette dernière, il existe aujourd'hui plusieurs solutions. La première solution consiste à réaliser sur la face de la plaque des pistes de connexion électrique, les pistes atteignant les plots des rangées situées en arrière des rangées latérales devant passer entre les plots de ces rangées latérales. Une autre solution, souvent mise en oeuvre avec la première, consiste à prévoir des vias de connexion électrique ménagés entre les plots pour rejoindre des pistes réalisées en profondeur dans une plaque multi-couches.

La réalisation de pistes passant entre les plots est technologiquement conditionnée par la dimension du pas de la matrice de billes, la dimension des billes et la largeur des pistes, en tenant compte éventuellement des effets électromagnétiques perturbateurs qui obligent à une distance minimum entre les plots et les pistes et entre les pistes adjacentes.

La réalisation de plaques multi-couches et de vias de connexion électrique oblige à la mise en oeuvre de moyens spécifiques de fabrication, relativement onéreux.

Selon un aspect de l'invention, il est proposé une plaque de connexion électrique mieux adaptée aux conditions technologiques de fabrication et à la nécessité de réduire les coûts de fabrication.

Selon un autre aspect de l'invention, il est proposé une plaque de connexion électrique qui, dans certains cas, ne nécessite pas la réalisation de vias de connexion électrique et la réalisation de plaques présentant plus de deux couches.

Un aspect de la présente invention est de proposer une plaque de connexion électrique tendant à réduire la dimension du pas d'une matrice de billes et en conséquence à réduire les dimensions des composants semi-conducteurs.

Selon un autre aspect de l'invention, il est proposé, pour certaines applications, une disposition particulière des plots de connexion électrique sur la plaque, associée à une disposition particulière des pistes de connexion électrique reliées à ces plots.

Selon un mode de réalisation, il est proposé une plaque de connexion électrique qui comprend, sur une face, des plots de connexion électrique en vue de connecter un composant semi-conducteur et des pistes de connexion électrique reliées respectivement à ces plots, ces plots étant disposés selon une matrice carrée présentant deux directions orthogonales.

Selon une caractéristique générale, ladite plaque comprend, sur ladite face, une multiplicité de groupes identiques adjacents de connexion électrique ;

Chaque groupe comprend N plots adjacents placés selon une première direction de ladite matrice et N pistes placées selon cette direction en allant vers un bord de la matrice ;

Les N pistes comprennent une piste centrale reliée à un plot d'extrémité situé du côté dudit bord de la matrice et des pistes latérales disposées de telle sorte que, lorsque le nombre de plots N est égal à un nombre impair, le nombre de pistes latérales passant de chaque côté dudit plot d'extrémité est égal à la moitié du nombre de plots N moins un ((N-1)/2) et que, lorsque le nombre de plots N est égal à un nombre pair, le nombre de pistes latérales passant d'un côté dudit plot d'extrémité est égal à la moitié (N/2) du nombre de plots N et le nombre de pistes latérales passant de l'autre côté de ce dudit plot d'extrémité est égal à la moitié du nombre de plots N moins un ((N-1)/2).

Selon l'invention, les plots d'un groupe sont, selon chaque direction de la matrice, décalés d'un pas par rapport aux plots du groupe adjacent ;

Selon l'invention, le décalage selon ladite première direction est tel qu'entre les plots d'extrémité situés du côté dudit bord de la matrice passe un nombre de pistes latérales égal au nombre de plots N moins un (N-1) et qu'entre le plot d'extrémité d'un groupe et le second plot de l'autre groupe, adjacents selon la seconde direction de la matrice, passe un nombre de pistes latérales égal au nombre de plots N moins deux (N-2).

Selon un mode de réalisation, chaque groupe comprend trois plots adjacents et trois pistes, dont une piste centrale reliée à un premier plot, deux pistes latérales passant de part et d'autre du premier plot et reliées respectivement à un second et un troisième plots, le décalage selon ladite première direction étant tel qu'entre les plots d'extrémité situés du côté dudit bord de la matrice passent deux pistes latérales et qu'entre le plot d'extrémité d'un groupe et le second plot de l'autre groupe, adjacents selon la seconde direction de la matrice, passe une piste latérale.

Selon un autre mode de réalisation, chaque groupe comprend quatre plots adjacents et quatre pistes, dont une piste centrale reliée à un premier plot, une piste latérale passant d'un côté et à côté du premier plot et deux pistes latérales passant de part et d'autre du premier plot et reliées respectivement à un troisième et un quatrième plots, le décalage selon ladite première direction étant tel qu'entre les plots d'extrémité situés du côté dudit bord de la matrice passent trois pistes latérales et qu'entre le plot d'extrémité d'un groupe et le second plot de l'autre groupe, adjacents selon la seconde direction de la matrice, passent deux pistes latérales.

Selon un autre mode de réalisation, chaque groupe comprend cinq plots adjacents et cinq pistes, dont une piste centrale reliée à un premier plot, deux pistes latérales passant de part et d'autre et à côté du premier plot et reliées respectivement à un second et un troisième plots et deux pistes latérales passant de part et d'autre du premier, du second et du troisième plots et reliées respectivement à un quatrième et un cinquième plots, le décalage selon ladite première direction étant tel qu'entre les plots d'extrémité situés du côté dudit bord de la matrice passent quatre pistes latérales et qu'entre le plot d'extrémité d'un groupe et le second plot de l'autre groupe, adjacents selon la seconde direction de la matrice, passent trois pistes latérales.

La présente invention a également pour objet un assemblage d'un composant semi-conducteur présentant, sur une face, des plots de connexion électrique et d'une plaque de connexion électrique telle que définie ci-dessus, les plots de connexion électrique du composant semi-conducteur étant reliés auxdits plots de connexion électrique de ladite plaque par l'intermédiaire de billes de connexion électrique.

La présente invention sera mieux comprise à l'étude de plaques de connexion électrique munies de différents dispositifs de connexion électriques, décrites à titre d'exemples non-limitatifs et illustrés par le dessin annexé sur lequel :
- La figure 1 représente une vue générale en coupe d'un assemblage comprenant une plaque de connexion électrique ;
- La figure 2 représente une vue frontale de ladite plaque, munie de premiers groupes élémentaires de connexion d'une première disposition selon l'invention ;
- La figure 3 représente une vue frontale de ladite plaque, munie de seconds groupes élémentaires de connexion de ladite première disposition selon l'invention ;
- La figure 4 représente une vue frontale de ladite plaque, munie de ladite première disposition selon l'invention ;
- La figure 5 représente une vue frontale de ladite plaque, munie de groupes élémentaires de connexion d'une seconde disposition selon l'invention ;
- La figure 6 représente une vue frontale de ladite plaque, munie de ladite seconde disposition selon l'invention ;
- La figure 7 représente une vue frontale de ladite plaque, munie de groupes élémentaires de connexion d'une troisième disposition selon l'invention ;
- Et la figure 8 représente une vue frontale de ladite plaque, munie de ladite troisième disposition selon l'invention.

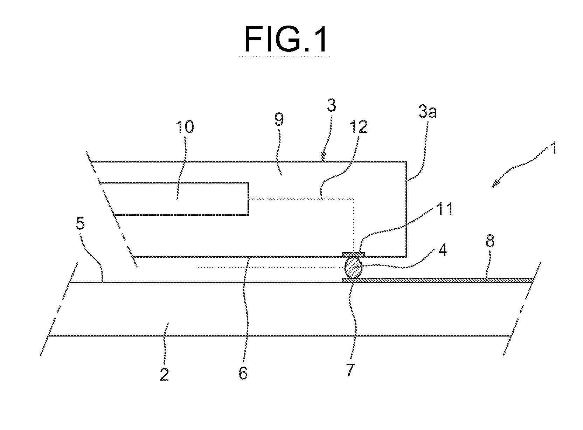

En se reportant à la figure 1, on peut voir qu'on a représenté un assemblage 1 comprenant une plaque de connexion électrique 2, un composant semi-conducteur 3 et une multiplicité de billes de connexion électrique 4 installées dans un espace séparant une face 5 de la plaque et une face 6 du composant semi-conducteur 3, ces faces 5 et 6 s'étendant parallèlement l'une à l'autre et étant situées à distance l'une de l'autre.

La plaque 2 présente, sur sa face 5, une multiplicité de plots de connexion électrique 7 sur lesquels sont respectivement soudées les billes de connexion électrique 4 et une multiplicité de pistes de connexion électrique 8, ne se coupant pas, respectivement reliées aux plots de connexion électrique 7 et permettant de relier électriquement le composant 3 à d'autres composants électroniques portés par la plaque 2 .

Selon une variante, le composant semi-conducteur 3 comprend un boîtier 9 dans lequel est insérée une puce de circuits intégrés 10. La face 6 du composant semi-conducteur 3 présente une multiplicité de plots de connexion électrique 11 sur lesquels sont respectivement soudées les billes de connexion électrique 4, ces plots 11 étant reliés électriquement à la puce de circuits intégrés 10 par des lignes ou fils de connexion électrique 12 inclus dans le boîtier 9.

Les billes de connexion électrique 4 servent en même temps de liaison mécanique entre la plaque 2 et le composant 3.

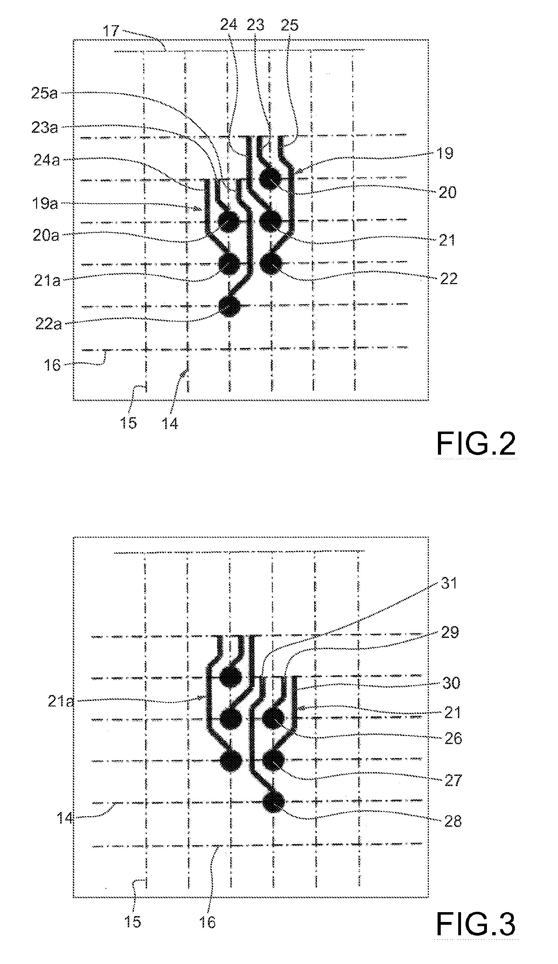

En se reportant aux figures 2, 3 et 4, on va maintenant décrire une première disposition 13 de plots de connexion électrique et de pistes de connexion électrique sur la face 5 de la plaque de connexion électrique 2, et en conséquence une première disposition de billes de connexion électrique et de plots sur la face 6 du composant semi-conducteur 3.

La première disposition 13 est formée de telle sorte que les plots correspondants de la face 6 du composant semi-conducteur 9 soient sur la périphérie de cette face 6.

Les plots de connexion électrique de cette première disposition 13 sont formés sur certaines intersections géométriques d'une matrice carrée 14 présentant deux directions orthogonales 15 et 16, parallèles aux flancs du composant semi-conducteur 3. Cette matrice présente un bord ou côté 17 parallèle à un flanc 3a de ce composant 3 et situé du côté de ce flanc, de telle sorte que la direction 15 s'étende perpendiculairement au bord 17 et la direction 16 s'étende parallèlement à ce bord 17.

La première disposition 13 comprend un premier arrangement 18 de plusieurs premiers groupes élémentaires identiques adjacents 19 et un second arrangement 20 de plusieurs seconds groupes élémentaires identiques adjacents 21.

Comme le montre la figure 2, chaque premier groupe de connexion électrique 19 comprend trois plots adjacents de connexion électrique, placés selon la direction 15 de la matrice 14, dont un premier plot d'extrémité 20 situé du côté du bord 17 de la matrice 14, un second plot 21 et un troisième plots 22, ainsi que trois pistes de connexion électrique, dont une piste centrale 23 et deux pistes latérales 24 et 25, ces pistes s'étendant substantiellement parallèlement à la direction 15 de la matrice 14, en direction du bord 17 de cette matrice 14

La piste centrale 23 est reliée au plot d'extrémité 20. La piste latérale 24 passe à côté du plot d'extrémité 20, à gauche de ce dernier en allant vers le bord 17 de la matrice 14, et rejoint en étant inclinée le second plot 21. La piste latérale 24 passe à côté du plot d'extrémité 20 et du second plot 21, à droite de ces derniers en allant vers le bord 17 de la matrice 14, et rejoint en étant inclinée le troisième plot 22.

Comme le montre la figure 2, deux premiers groupes élémentaires adjacents 19 et 19a d'un premier arrangement 18 sont disposés de telle sorte que les plots 20a, 21 a et 22a du groupe 14a sont décalés d'un pas selon la direction 15 de la matrice 14 et d'un pas selon la direction 16 de cette matrice 14. Les groupes 19 et 19a sont alors décalés diagonalement d'un pas.

En supposant que le groupe 19a est décalé d'un pas selon la direction 16, à gauche du groupe 19 en allant vers le bord 17 de la matrice 14, le groupe 19a est éloigné d'un pas du bord 17 de la matrice 14 par rapport au groupe 19. C'est l'exemple représenté sur la figure 2.

I1 en résulte la configuration suivante.

Les plots 20a, 21a et 22a du groupe 19a sont éloignés d'un pas du bord 17 de la matrice 14 par rapport aux plots 20, 21 et 22 du groupe 19.

La piste 25a du groupe 19a passe entre la piste 24 du groupe 19, les pistes 24, la piste 24 des groupes 19 et 19a passant ainsi entre les plots d'extrémité 20 et 20a des groupes 19 et 19a.

La piste 25a du groupe 19a passe entre le second plot du groupe 19 et le plot d'extrémité 20 du groupe 19a et entre le troisième plot 22 du groupe 19 et le second plot 21 a du groupe 19a.

En adoptant successivement le décalage ci-dessus, on peut former un arrangement 18 de N groupes de connexion électrique 19, identiques et adjacents. Les plots correspondants sont disposés de façon alignée selon des diagonales adjacentes de la matrice 14.

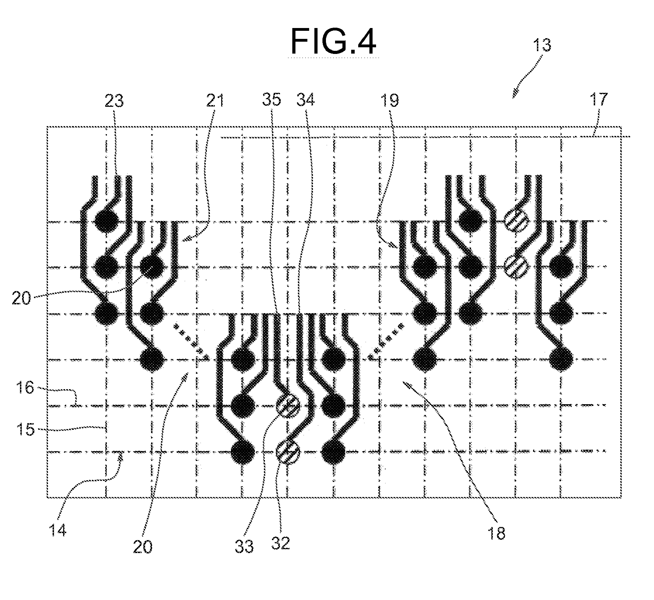

Sur la figure 4, on peut voir qu'on a prévu, sur la face 5 de la plaque 2, un arrangement 18 de quatre premiers groupes identiques adjacents 19 de connexion électrique. Un tel arrangement est disposé sur quatre directions 15 adjacentes et sur six directions 16 adjacentes.

I1 résulte de ce qui précède qu'entre deux plots adjacents selon la direction 16 ne passe qu'une seule piste et qu'entre deux premiers plots d'extrémité adjacents, situés sur une diagonale de la matrice 14, ne passe que deux pistes, ces deux pistes présentant à cet endroit une portion en diagonale de la matrice 14.

En se reportant à la figure 3, on peut voir que chaque second groupe de connexion électrique 21 comprend trois plots adjacents 26, 27 et 28 de connexion électrique, placés selon une direction 15 de la matrice 14, ainsi que trois pistes de connexion électrique 29, 30 et 31 s'étendant substantiellement parallèlement à la direction 15 de la matrice 14, en direction du bord 17 de cette matrice 14.

La disposition des pistes 29, 30 et 31 du second groupe 21 est symétrique aux pistes 23, 24 et 25 du groupe 19, par rapport à la direction 15 de la matrice 14.

Le décalage d'un second groupe 21a adjacent au groupe 21 est aussi symétrique par rapport au décalage décrit à propos des groupes adjacents 19 et 19a.

En adoptant successivement ce décalage symétrique, on peut former un arrangement 20 de N groupes de connexion électrique 21, identiques et adjacents, dont les plots correspondants sont disposés selon des diagonales adjacentes de la matrice 14, symétriques par rapport à une direction 15 de la matrice 14, les diagonales d'un arrangement 18 s'étendant perpendiculairement aux diagonales d'un arrangement 20.

Sur la figure 4, on a représenté un arrangement 20 de quatre seconds groupes identiques adjacents 19 de connexion électrique. Comme précédemment, un tel arrangement est disposé sur quatre directions 15 adjacentes et sur 6 directions 16 adjacentes.

Sur la figure 4, on peut voir également qu'on a prévu, sur la face 5 de la plaque 2, un arrangement 20 de quatre seconds groupes identiques adjacents 21 de connexion électrique. Un tel arrangement est disposé sur quatre directions 15 adjacentes et sur six directions 16 adjacentes.

Avantageusement, comme le montre la figure 3, un arrangement 18 et un arrangement 20 peuvent être associés de telle que leurs plots correspondants soient disposés sur les mêmes directions 16 de la matrice 14, en présentant des groupes d'extrémité situés en vis-à-vis selon la direction 16 et décalés de deux pas selon cette direction 16. Deux arrangements 18 et 20 ainsi disposés forment soit un V ouvert du côté du bord 17 de la matrice 14, soit un V ouvert à l'opposé.

Avantageusement, la direction 15 de la matrice 14, passant entre les arrangements 18 et 20, peut présenter deux plots de comblement 32 et 33, placés soit entre les seconds et troisièmes plots desdits groupes d'extrémité lorsque ledit V est ouvert du côté du bord 17 de la matrice 14 soit entre les premiers et seconds plots desdits groupes d'extrémité lorsque ledit V est ouvert à l'opposé du bord 17 de la matrice 14, ainsi que deux pistes 34 et 35 reliées à ces plots 32 et 33.

Avantageusement, des arrangements 18 et 20 peuvent être répartis en correspondance avec les quatre flancs du composant semi-conducteur 3. Les points de la matrice 14 situés entre les extrémités extérieures de deux arrangements adjacents dans la zone des coins du composant semi-conducteur 3 peuvent en outre présenter, sur la face 5 de la plaque 2, des plots de comblement reliés à des pistes.

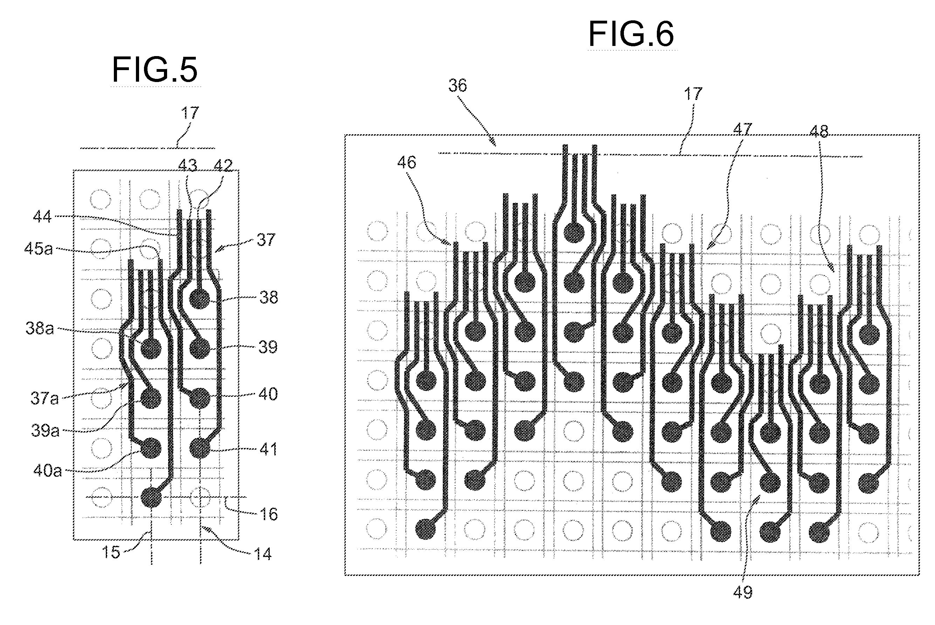

En se reportant aux figures 5 et 6, on va maintenant décrire une seconde disposition 36, en faisant référence à la matrice 14, à ses directions 15 et 16 et à son bord ou côté 17.

Cette seconde disposition 36 se différencie de la première disposition 13 par le fait que ses groupes élémentaires de connexion électrique 37 comprennent quatre plots de connexion électrique adjacents et alignés, placés selon la direction 15 de la matrice 14, dont un premier plot d'extrémité 38 situé du côté du bord 17 de la matrice 14, un second plot 39, un troisième plot 40 et un quatrième plot 41.

Cette seconde disposition 36 se différencie aussi de la première disposition 13 par le fait que chaque groupe 37 présente quatre pistes de connexion électrique, dont une piste centrale 42 reliée au premier plot d'extrémité 38, une piste latérale 43 passant d'un côté de ce premier plot 38 et se prolongeant jusqu'au second plot 39, et deux pistes latérales 44 et 45 passant de part et d'autre des premier et second plots 38 et 39 et se prolongeant respectivement, indifféremment, jusqu'aux troisième et au quatrième plots 40 et 41. De plus, la piste latérale 43 passe entre le premier plot 38 et la piste latérale 44.

Comme précédemment, des groupes de connexion électrique 37 peuvent être placés de façon adjacente en étant successivement décalés d'un pas selon la direction 15 et la direction 16 de la matrice 14, de façon à constituer des arrangements 46 ou 47 dont les groupes sont symétriques par rapport à la direction 15 de la matrice 14..

Selon cette variante, comme le montre en particulier la figure 5, ces arrangements sont tels que la piste 44 d'un groupe 45 est adjacente à la piste 45a d'un groupe adjacent 37a, ce groupe 37a étant décalé d'un pas selon la direction 15 de la matrice l'éloignant du bord 17 de cette matrice.

I1 en résulte la configuration suivante.

Entre les premiers plots d'extrémité 38 et 38a de deux groupes adjacents 37 et 37a, passent trois pistes, à savoir les pistes 43 et 44 d'un groupe 37 et la piste 45a d'un groupe 37a adjacent.

Entre le second plot 39 d'un groupe 37 et le premier plot d'extrémité d'un groupe adjacent 37a, passent deux pistes, à savoir la piste 44 du groupe 37 et la piste 45a du groupe adjacent 37a.

Entre le troisième plot 40 d'un groupe 37 et le second plot 39a d'un groupe adjacent 37a, passe la piste 45a du groupe adjacent 37a, cette piste passant aussi entre le quatrième plot 41 d'un groupe 37 et le troisième plot 39a d'un groupe adjacent 37a.

Comme à propos de la disposition 13, la disposition 36 peut comprendre des arrangements adjacents 46 et 47 formant des V ouverts à l'opposé de ce bord 17 de la matrice 14 ou des arrangements adjacents 47 et 48 formant des V ouverts du côté du bord 17.

Avantageusement, les arrangements 47 et 48 sont séparés de deux pas selon la direction 16 de la matrice 14. Un groupe particulier 49 de trois plots adjacents et de trois pistes peut être placé sur la direction 16 séparant ces arrangements 47 et 48.

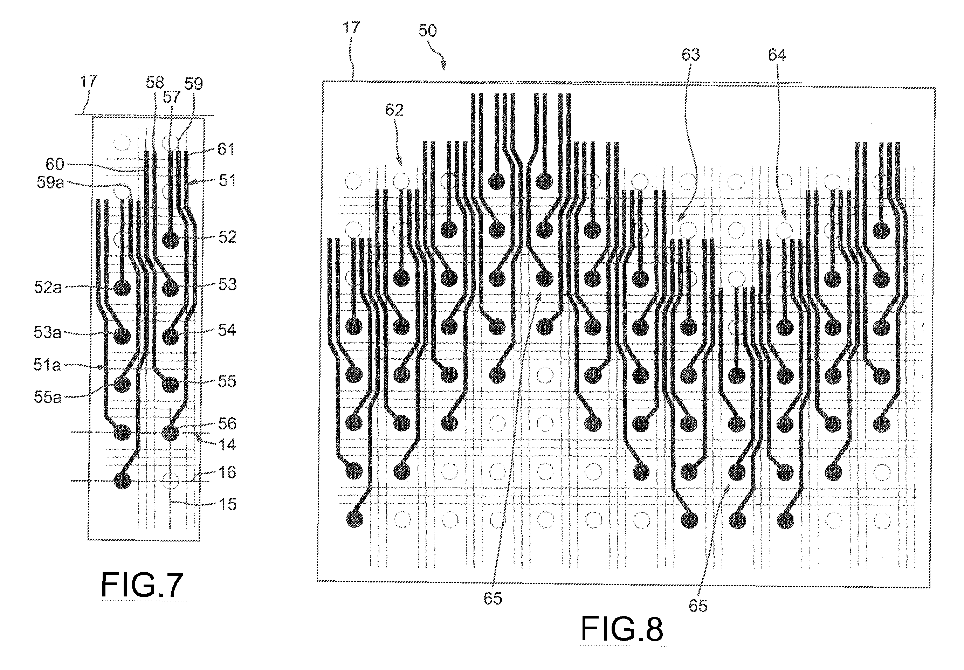

En se reportant aux figures 7 et 8, on va maintenant décrire une troisième disposition 50, en faisant référence à la matrice 14, à ses directions 15 et 16 et à son bord ou côté 17.

Cette troisième disposition 50 se différencie des dispositions précédentes par le fait que ses groupes élémentaires de connexion électrique 51 comprennent cinq plots de connexion électrique adjacents et alignés, placés selon la direction 15 de la matrice 14, dont un premier plot d'extrémité 52 situé du côté du bord 17 de la matrice 14, un second plot 53, un troisième plot 54, un quatrième plot 55 et un cinquième plot 56.

Cette troisième disposition 50 se différencie aussi des dispositions précédentes par le fait que chaque groupe 50 présente cinq pistes de connexion électrique, dont une piste centrale 57 reliée au premier plot d'extrémité 52, une piste latérale 58 passant d'un côté de ce premier plot 52 et se prolongeant jusqu'au second plot 53, une piste latérale 59 passant de l'autre côté du premier plot 52 et se prolongeant respectivement jusqu'au troisième plot 54, en passant à côté du deuxième plot 53, et deux pistes latérales 60 et 61 passant de part et d'autre des premier, second et troisième plots 52, 53 et 54 et se prolongeant respectivement, indifféremment, jusqu'aux quatrième et cinquième plots 55 et 56. De plus, la piste latérale 58 passe entre le premier plot 38 et la piste latérale 60 et la piste latérale 59 passe entre les premier et second plots 52 et 53 et la piste latérale 61.

Comme précédemment, des groupes de connexion électrique 51 peuvent être placés de façon adjacente en étant successivement décalés d'un pas selon la direction 15 et la direction 16 de la matrice 14, de façon à constituer des arrangements 62 ou 63 dont les groupes sont symétriques par rapport à la direction 15 de la matrice 14..

Comme le montre en particulier la figure 5, ces arrangements sont tels que la piste 60 d'un groupe 51 est adjacente à la piste 61a d'un groupe adjacent 51a, ce groupe 51a étant décalé d'un pas selon la direction 15 de la matrice l'éloignant du bord 17 de cette matrice.

I1 en résulte la configuration suivante.

Entre les premiers plots d'extrémité 52 et 52a de deux groupes adjacents 51 et 51a, passent quatre pistes, à savoir les pistes 57 et 58 d'un groupe 51 et les pistes 59a et 61a d'un groupe 51a adjacent.

Entre le second plot 53 d'un groupe et le premier plot d'extrémité 52a d'un groupe adjacent 51a, passent trois pistes, à savoir la piste 60 du groupe 51 et les pistes 59a et 61a du groupe adjacent 51a.

Entre le troisième plot 54 d'un groupe 51 et le deuxième plot 53a d'un groupe adjacent 51a, passent encore les pistes 59a, 60 et 61a.

Entre le quatrième plot 55 d'un groupe 51 et le troisième plot 54a d'un groupe adjacent 51a, passe la piste 61a du groupe 51a, la piste 61a passant également entre le cinquième plot 56 d'un groupe 51 et le quatrième plot 55a d'un groupe adjacent 51a.

Comme à propos des dispositions précédentes, la disposition 50 peut comprendre des arrangements adjacents 62 et 63 formant des V ouverts à l'opposé de ce bord 17 de la matrice 14 ou des arrangements adjacents 63 et 64 formant des V ouverts du côté du bord 17.

Avantageusement, les arrangements 62 et 63 et les arrangements 63 et 64 sont séparés de deux pas selon la direction 16 de la matrice 14. Des groupes particuliers 65 de quatre plots adjacents et de quatre pistes peuvent être placés sur les directions 16 séparant les arrangements 47 et 48 et les arrangements 63 et 64.

D'une manière générale, dans les exemples qui viennent d'être décrits, les distances entre les différentes pistes et entre ces dernières et les plots sont de préférence sensiblement égales, le dessin des pistes étant au mieux réalisé pour obtenir des distances égales en leur conférant des changements de direction.

Les dispositions qui viennent d'être décrites sont choisies en fonction du nombre de liaisons électriques souhaitées du composant semi-conducteur 3 avec d'autres composants électroniques montés sur la plaque 2, sans autre moyen de connexion électrique. Néanmoins, des liaisons électriques peuvent être prévues dans la partie centrale du composant semi-conducteur 3, par l'intermédiaire de billes de connexion électrique, ces liaisons comprenant des vias de connexion électrique ménagés dans la plaque 2 et atteignant soit des pistes formées sur la face de la plaque 2 opposée à sa face 5 soit des pistes intégrées à cette plaque.

Bien entendu, on pourrait rajouter des plots de connexion électrique, adjacents ou non aux plots intérieurs précités, qui pourraient être reliés à des pistes de connexion électrique formées en profondeur dans une plaque multicouche, à deux couches, à trois couches, ou à plus de trois couches.

## Revendications

1. Plaque de connexion électrique comprenant, sur une face, des plots de connexion électrique en vue de connecter un composant semi-conducteur et des pistes de connexion électrique reliées respectivement à ces plots, ces plots étant disposés selon une matrice carrée présentant deux directions orthogonales,
**caractérisée par le fait qu'**elle comprend, sur ladite face, une multiplicité de groupes identiques adjacents de connexion électrique (19) ;
que chaque groupe comprend N plots adjacents (20) placés selon une première direction de ladite matrice et N pistes (23) placées selon cette direction en allant vers un bord de la matrice ;
que les N pistes comprennent une piste centrale reliée à un plot d'extrémité situé du côté dudit bord de la matrice et des pistes latérales disposées de telle sorte que, lorsque le nombre de plots N est égal à un nombre impair, le nombre de pistes latérales passant de chaque côté dudit plot d'extrémité est égal à la moitié du nombre de plots N moins un ((N-1)/2) et que, lorsque le nombre de plots N est égal à un nombre pair, le nombre de pistes latérales passant d'un côté dudit plot d'extrémité est égal à la moitié (N/2) du nombre de plots N et le nombre de pistes latérales passant de l'autre côté de ce dudit plot d'extrémité est égal à la moitié du nombre de plots N moins un ((N-1)/2) ;
que les plots d'un groupe sont, selon chaque direction de la matrice, décalés d'un pas par rapport aux plots du groupe adjacent ;
et que le décalage selon ladite première direction est tel qu'entre les plots d'extrémité situés du côté dudit bord de la matrice passe un nombre de pistes latérales égale au nombre de plots N moins un (N-1) et qu'entre le plot d'extrémité d'un groupe et le second plot de l'autre groupe, adjacents selon la seconde direction de la matrice, passe un nombre de pistes latérales égale au nombre de plots N moins deux (N-2).

2. Plaque de connexion électrique selon la revendication 1, **caractérisée par le fait que**
chaque groupe comprend trois plots adjacents (20, 21, 22) et trois pistes, dont une piste centrale (23) reliée à un premier plot et deux pistes latérales (24, 25) passant de part et d'autre du premier plot et reliées respectivement à un second et un troisième plots ;
et que le décalage selon ladite première direction est tel qu'entre les plots d'extrémité situés du côté dudit bord de la matrice passent deux pistes latérales et qu'entre le plot d'extrémité d'un groupe et le second plot de l'autre groupe, adjacents selon la seconde direction de la matrice, passe une piste latérale.

3. Plaque de connexion électrique selon la revendication 1, **caractérisée par le fait que**
chaque groupe comprend quatre plots adjacents (38, 39, 40, 41) et quatre pistes, dont une piste centrale (42) reliée à un premier plot, une piste latérale (43) passant d'un côté et à côté du premier plot et deux pistes latérales (44, 45) passant de part et d'autre du premier plot et reliées respectivement à un troisième et un quatrième plots ;
et que le décalage selon ladite première direction est tel qu'entre les plots d'extrémité situés du côté dudit bord de la matrice passent trois pistes latérales et qu'entre le plot d'extrémité d'un groupe et le second plot de l'autre groupe, adjacents selon la seconde direction de la matrice, passent deux pistes latérales.

4. Plaque de connexion électrique selon la revendication 1, **caractérisée par le fait que**
chaque groupe comprend cinq plots adjacents (52, 53, 54, 55, 56) et cinq pistes, dont une piste centrale (57) reliée à un premier plot, deux pistes latérales (58, 59) passant de part et d'autre et à côté du premier plot et reliées respectivement à un second et un troisième plots et deux pistes latérales (60, 61) passant de part et d'autre du premier, du second et du troisième plots et reliées respectivement à un quatrième et un cinquième plots ;
et que le décalage selon ladite première direction est tel qu'entre les plots d'extrémité situés du côté dudit bord de la matrice passent quatre pistes latérales et qu'entre le plot d'extrémité d'un groupe et le second plot de l'autre groupe, adjacents selon la seconde direction de la matrice, passent trois pistes latérales.

5. Assemblage d'un composant semi-conducteur présentant, sur une face, des plots de connexion électrique et d'une plaque selon l'une quelconque des revendications précédentes, les plots de connexion électrique (11) du composant semi-conducteur (3) étant reliés auxdits plots de connexion électrique (7) de ladite plaque (2) par l'intermédiaire de billes de connexion électrique (4).
